# FASCICULE DE BREVET EUROPEEN

(11) **EP 2 223 267 B1**
(45) Date de publication et mention de la délivrance du brevet: **10.09.2014**
(21) Numéro de dépôt: 08872333.3
(22) Date de dépôt: 05.12.2008
(51) Int. Cl.: G06K 19/06, H01L 51/52, G06K 9/00

(54) **PROCÉDÉ DE FABRICATION D'UN DISPOSITIF D'IDENTIFICATION ET D'AUTHENTIFICATION À BASE DE DIODE ORGANIQUE, DISPOSITIF ET PROCÉDÉ D'UTILISATION**
VERFAHREN ZUR HERSTELLUNG EINER IDENTIFIKATIONS-/AUTHENTIFIKATIONSVORRICHTUNG AUF BASIS ORGANISCHER DIODEN, BESAGTE VORRICHTUNG UND VERFAHREN ZU IHRER VERWENDUNG
PROCESS FOR FABRICATING AN ORGANIC-DIODE-BASED IDENTICATION/AUTHENTICATION DEVICE, SAID DEVICE AND METHOD OF USE

(30) Priorité: 20.12.2007 FR 0708953
(43) Date de publication de la demande: 01.09.2010
(73) Titulaire: COMMISSARIAT A L'ENERGIE ATOMIQUE ET AUX ENERGIES ALTERNATIVES, 75015 Paris (FR)
(72) Inventeur: MAINDRON, Tony, F-3800 Grenoble (FR)
(74) Mandataire: Dubreu, Sandrine
(86) Numéro de dépôt international: PCT/FR2008/001698
(87) Numéro de publication internationale: WO 2009/101295

(56) Documents cités:
- US-B1- 6 635 988

## Description

### Domaine technique de l'invention

L'invention est relative à un procédé de fabrication d'un dispositif d'identification et d'authentification d'un objet, comportant la formation dans le dispositif d'une pluralité d'éléments d'identification distribués aléatoirement.

### État de la technique

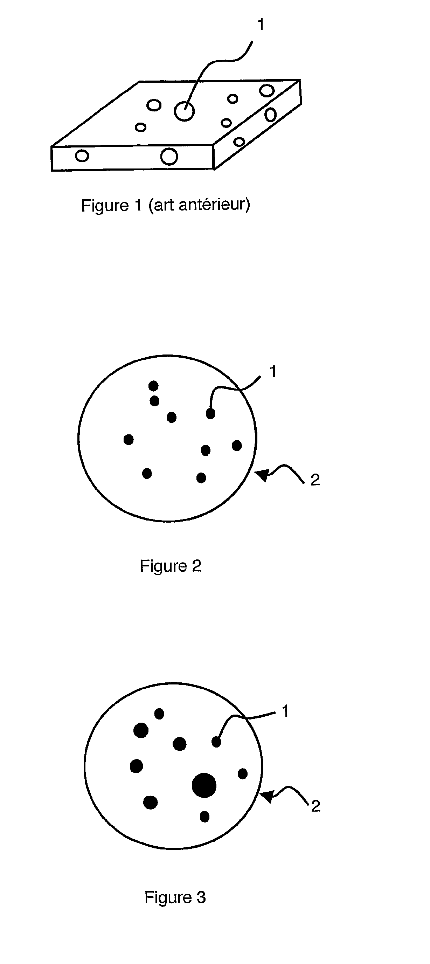

Le document WO-A-01/57831 décrit un procédé et un dispositif d'identification et d'authentification d'objets, de végétaux ou d'êtres vivants. Ce procédé met en oeuvre la réalisation d'un d'identificateur volumique à partir d'un mélange hétérogène et durcissant d'au moins deux corps non miscibles. L'identificateur volumique comporte des hétérogénéités aléatoires et statistiquement non reproductibles en forme et en position, garantissant l'unicité de l'identificateur. Dans le cas d'un mélange gazeux avec un produit liquide ou pâteux, illustré à la figure 1, on obtient des hétérogénéités en forme de bulles 1 de ce même gaz. Ainsi, des bulles de diamètre aléatoire sont formées dans le mélange à des emplacements aléatoires et peuvent servir d'éléments d'identification 1. Les éléments d'identification 1 sont noyés dans le volume et de ce fait ne sont pas accessibles par contact direct. Ils ne peuvent donc pas être soumis à l'usure ou à l'endommagement comme un code barre peut l'être sur un support papier. Ce procédé peut aussi être mis en oeuvre en mélangeant des particules solides à un produit durcissant, la répartition de ces particules étant fixée aléatoirement une fois le produit figé, formant alors des éléments d'identification.

Après la fabrication de l'identificateur, celui-ci est numérisé par plusieurs séries d'images permettant une reconstruction fidèle en trois dimensions de l'identificateur. Cette image en trois dimensions est stockée dans une base de données. L'identificateur est ensuite attribué à un objet. Un identificateur peut, par la suite, être utilisé pour authentifier un objet. Il est alors numérisé selon une pluralité d'angles permettant sa reconstruction en trois dimensions. Puis la base de données est interrogée afin de vérifier instantanément l'authenticité de l'identificateur en le comparant aux données de la base. Un tel identificateur en trois dimensions est infalsifiable. Cependant l'utilisation de cet identificateur est relativement complexe en raison de la reconstruction en trois dimensions après l'acquisition d'une série d'images sous des angles de vue différents.

Le document US 6,635,988 divulgue une diode électroluminescente dont la structure empêche l'humidité de détériorer la diode.

### Objet de l'invention

L'invention a pour objet la réalisation d'un dispositif d'identification et d'authentification d'objets, de végétaux, de personnes, d'animaux ou de services qui soit simple et infalsifiable.

Selon l'invention, ce but est atteint par le fait que, le dispositif comportant au moins une diode organique électroluminescente, le procédé comporte, avant encapsulation du dispositif, une étape d'exposition de la diode à au moins un gaz pour former, par altération, lesdits éléments d'identification sous forme de points noirs distribués aléatoirement et visibles par électroluminescence, le dispositif étant encapsulé dans un boîtier hermétique sous atmosphère inerte après formation des éléments d'identification.

L'invention concerne aussi un dispositif obtenu par ce procédé et comportant une diode organique avec des éléments d'identification sous forme de points noirs distribués aléatoirement sur une surface de la diode et visibles en électroluminescence.

L'invention concerne en outre un procédé d'utilisation de ce dispositif, comportant une mise sous tension de la diode, une détermination de la distribution surfacique des points noirs et une comparaison de cette distribution à des images préenregistrées associées aux objets à identifier.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre un identificateur selon l'art antérieur.
Les figure 2 à 4 illustrent, en vue de dessus, trois variantes de réalisation de l'invention.

### Description des modes particuliers de réalisation

Selon un mode de réalisation illustré à la figure 2, un dispositif d'identification et d'authentification d'un objet comporte une pluralité d'éléments d'identification 1 distribués aléatoirement. Un tel dispositif comporte au moins une diode organique 2 électroluminescente et est réalisé par:
- une exposition de la diode organique à au moins un gaz pour former, par altération de la diode, des éléments d'identification sous forme de points noirs distribués aléatoirement et visibles par électroluminescence,
- une encapsulation de la diode pour arrêter son altération.

Il est ainsi possible d'obtenir un identificateur à base de diodes organiques électroluminescentes, qui comportent classiquement une anode recouverte par au moins une couche organique émissive par électroluminescence, puis une cathode. On utilise en fait un des inconvénients majeurs des diodes organiques, à savoir leur sensibilité à l'humidité. En effet, lorsqu'une diode organique est exposée à l'atmosphère, elle s'altère en certains points, formant des points noirs. Cette altération, due à des défauts de structure, n'apparaît pas en temps normal, si le procédé d'élaboration des diodes organiques est bien maîtrisé, c'est-à-dire lorsque les diodes organiques sont réalisées dans une boîte à gant sous atmosphère inerte (gaz ou argon), en évitant toute pénétration d'eau sous forme de vapeur. L'invention utilise ces défauts de structure dont la répartition est aléatoire, et donc non reproductible, pour former l'identificateur.

Les points noirs correspondent à des zones, sous forme de minuscules trous (« pinholes » en anglais), qui deviennent incapables d'émettre de la lumière. Ainsi, lorsque la diode est alimentée, des points noirs, normalement invisibles apparaissent par électroluminescence. L'invention consiste à faire apparaître volontairement des points noirs en exposant la diode organique électroluminescente quelques minutes à l'atmosphère ou à une atmosphère contrôlée dans une chambre climatique, avant de l'encapsuler.

La diode est, de préférence, exposée à de la vapeur d'eau, dans une chambre climatique. L'altération correspond à la pénétration de la vapeur d'eau dans la diode organique.

La diode est ensuite encapsulée, de préférence, dans un boîtier comportant un gaz inerte, par exemple du diazote (N₂) ou de l'argon (Ar). Cette encapsulation permet de figer la répartition surfacique des points noirs en empêchant des molécules d'eau de pénétrer ultérieurement dans la diode.

Les points noirs n'évoluant plus, ils créent un motif aléatoire, non reproductible et non falsifiable. Chaque point constitue ainsi un élément d'identification 1 pour la réalisation d'un identificateur 2 à base de diode organique.

L'encapsulation peut être réalisée, de manière classique, en utilisant un capot de verre collé, ou de manière monolithique en réalisant une encapsulation en couches minces avec des matériaux oxydes et/ou nitrures et/ou polymères. De préférence, un getter est placé sous le capot de verre afin d'absorber l'humidité résiduelle.

Il est possible, lors de la fabrication de la diode, d'augmenter le diamètre des points noirs en augmentant le temps d'exposition de la diode organique à l'atmosphère ou au gaz. En effet, suivant la taille des défauts de structure de la diode, l'infiltration du gaz est plus ou moins importante et l'altération de la diode plus ou moins rapide. Ainsi comme illustré à la figure 3, les points noirs peuvent avoir à la fois une distribution et une taille toutes deux aléatoires. Cette taille aléatoire supplémentaire permet d'augmenter de manière très importante la sécurité de l'identification.

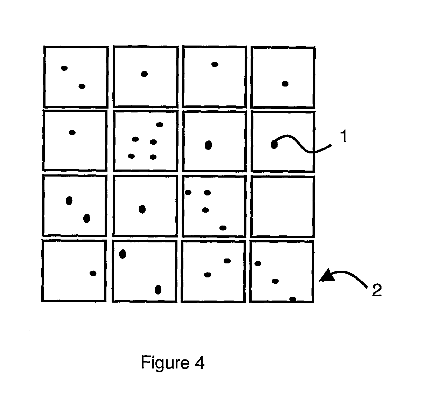

Selon un autre mode de réalisation, illustrée à la figure 4, un identificateur 2 peut être composé d'une pluralité de diodes élémentaires disposées sous forme d'une barre ou d'une matrice, constituant un écran. Ceci permet de rendre encore plus complexe la distribution surfacique des points noirs augmentant encore plus la sécurité. Le nombre de diodes élémentaires peut, par exemple, être de l'ordre de plusieurs centaines, chaque diode élémentaire constituant un pixel de l'écran.

Un tel identificateur est destiné à permettre l'authentification d'objets. On entend par objet tout type de végétaux, des êtres vivants, des biens matériels, ou encore des services. Une fois fabriqué, l'identificateur est mis sous tension puis une image de la distribution surfacique des points noirs est capturée et, de préférence, numérisée. Cette image peut être préenregistrée dans une base de donnée et associée à un objet. Lorsque l'objet doit être authentifié, l'identificateur est mis sous tension et la distribution surfacique des points noirs est déterminée, par exemple par une caméra, puis comparée avec les images préenregistrées dans la base de données pour vérifier l'authenticité l'objet.

De tels identificateurs ne sont pas falsifiable grâce à la répartition aléatoire des points noirs. La reconnaissance étant réalisée sur une répartition surfacique, elle est beaucoup plus simple à mettre en oeuvre que dans un identificateur en trois dimensions.

## Revendications

1. Procédé de fabrication d'un dispositif d'identification et d'authentification d'un objet, comportant la formation dans le dispositif d'une pluralité d'éléments d'identification (1) distribués aléatoirement, le dispositif comportant au moins une diode organique électroluminescente, le procédé comporte, avant encapsulation du dispositif, une étape d'exposition de la diode à au moins un gaz pour former, par altération, lesdits éléments d'identification (1) sous forme de points noirs distribués aléatoirement et visibles par électroluminescence, le procédé étant **caractérisé en ce que** le dispositif est encapsulé dans un boîtier hermétique sous atmosphère inerte après formation des éléments d'identification (1).

2. Procédé selon la revendication 1, **caractérisé en ce que** le gaz est de la vapeur d'eau.

3. Procédé selon la revendication 1 ou 2, **caractérisé en ce qu'**un getter est placé dans le boîtier.

4. Dispositif d'identification obtenu par le procédé selon l'une quelconque des revendications 1 à 3, **caractérisé en ce qu'**il comporte au moins une diode organique et une pluralité d'éléments d'identification (1) sous forme de points noirs distribués aléatoirement, visibles en électroluminescence.

5. Dispositif selon la revendication 4, **caractérisé en ce que** les points noirs ont une taille aléatoire.

6. Dispositif selon l'une des revendications 4 et 5, **caractérisé en ce qu'**il comporte une pluralité de diodes organiques formant un écran.

7. Procédé d'utilisation du dispositif selon l'une quelconque des revendications 4 à 6, **caractérisé en ce qu'**il comporte la mise sous tension de la diode, la détermination de la distribution surfacique des points noirs et la comparaison de cette distribution à des images préenregistrées associées aux objets à identifier.

## Patentansprüche

1. Verfahren zur Herstellung einer Vorrichtung zur Erkennung und Authentifizierung eines Gegenstandes, mit der Bildung einer Vielzahl von zufällig verteilten Erkennungselementen (1) in der Vorrichtung, wobei die Vorrichtung mindestens eine organische Leuchtdiode aufweist, wobei das Verfahren vor der Einkapselung der Vorrichtung einen Schritt umfasst, bei dem die Diode mindestens einem Gas ausgesetzt wird, um durch Veränderung die Erkennungselemente (1) in Form von zufällig verteilten und durch Elektrolumineszenz sichtbaren schwarzen Punkten auszubilden, wobei das Verfahren **dadurch gekennzeichnet ist, dass** die Vorrichtung nach der Bildung der Erkennungselemente (1) in ein luftdicht verschlossenes Gehäuse unter inerter Atmosphäre eingekapselt wird.

2. Verfahren gemäß Anspruch 1, **dadurch gekennzeichnet, dass** das Gas aus Wasserdampf besteht.

3. Verfahren gemäß Anspruch 1 oder 2, **dadurch gekennzeichnet, dass** in dem Gehäuse ein Getter angebracht ist.

4. Erkennungsvorrichtung, die durch das Verfahren gemäß einem der Ansprüche 1 bis 3 erhalten wird, **dadurch gekennzeichnet, dass** sie mindestens eine organische Diode und eine Vielzahl von Erkennungselementen (1) in Form von zufällig verteilten, in Elektrolumineszenz sichtbaren schwarzen Punkten aufweist.

5. Vorrichtung gemäß Anspruch 4, **dadurch gekennzeichnet, dass** die schwarzen Punkte eine zufällige Größe aufweisen.

6. Vorrichtung gemäß einem der Ansprüche 4 und 5, **dadurch gekennzeichnet, dass** sie eine Vielzahl von organischen Dioden aufweist, die einen Bildschirm bilden.

7. Verfahren zur Anwendung der Vorrichtung gemäß einem der Ansprüche 4 bis 6, **dadurch gekennzeichnet, dass** es die Spannungszuschaltung der Diode, die Festlegung der Flächenverteilung der schwarzen Punkte und den Vergleich dieser Verteilung mit zuvor aufgezeichneten, den zu erkennenden Gegenständen zugeordneten Bildern umfasst.

## Claims

1. Method for fabricating a device for identification and authentication of an object comprising formation of a plurality of randomly distributed identification elements (1) in the device, the device comprising at least one organic light-emitting diode, the method comprises an exposure stage of the diode to at least one gas, before packaging of the device, to form said identification elements (1) by impairment in the form of randomly distributed black spots visible by electroluminescence, method **characterized in that** the device is packaged in a sealed casing in an inert atmosphere after formation of the identification elements (1).

2. Method according to claim 1, **characterized in that** the gas is water vapor.

3. Method according to claim 1 or 2, **characterized in that** a getter is placed in the packaging casing.

4. Identification device obtained by the method according to any one of claims 1 to 3, **characterized in that** it comprises at least one organic diode and a plurality of identification elements (1) in the form of randomly distributed black spots visible in electroluminescence.

5. Device according to claim 4, **characterized in that** the black spots are of random size.

6. Device according to one of claims 4 and 5, **characterized in that** it comprises a plurality of organic diodes forming a screen.

7. Method for using the device according to any one of claims 4 to 6, **characterized in that** it comprises powering on of the diode, determination of the surface distribution of the black spots and comparison of this distribution with pre-recorded images associated with the objects to be identified.
